# EUROPÄISCHE PATENTSCHRIFT

(11) **EP 0 818 711 B1**
(45) Veröffentlichungstag und Bekanntmachung des Hinweises auf die Patenterteilung: **06.08.2003**
(21) Anmeldenummer: 97117794.4
(22) Anmeldetag: 22.09.1992
(51) Int. Cl.: G03F 1/00

(54) **Vorrichtung zum Aufbringen einer Abdeckflüssigkeit auf einen Zylinder**
Process and apparatus for the manufacturing of flexographic printing plates
Procédé et appareil pour la fabrication de plaques d'impression flexographiques

(43) Veröffentlichungstag der Anmeldung: 14.01.1998
(62) Teilanmeldung aus: 92116183.2
(73) Patentinhaber: Schablonentechnik Kufstein Aktiengesellschaft, 6330 Kufstein (AT)
(72) Erfinder: Fischer, Hannes, 6300 Wörgl (AT)
(74) Vertreter: TER MEER STEINMEISTER & PARTNER GbR

(56) Entgegenhaltungen:
- EP-A- 0 503 621
- GB-A- 732 435
- US-A- 1 671 620
- US-A- 3 092 686

## Beschreibung

Die Erfindung betrifft eine Vorrichtung zum Aufbringen einer Abdeckflüssigkeit auf einen Zylinder, und insbesondere zum Aufbringen einer Abdeckflüssigkeit auf die Oberfläche einer Fotoelasomerschicht zur Verwendung bei der Herstellung von Flexodruckformen.

Bei den genannten Flexodruckformen handelt es sich vorzugsweise um dünne Metallzylinder aus z. B. Nickel, die mit einem 2 bis 5 mm dicken Fotoelastomer beschichtet sind. Der Fotoelastomer wird durch Bestrahlung mit ultraviolettem Licht vernetzt und weist dann gegen Druckchemikalien und Lösemittel eine hohe Beständigkeit auf. Sein Elastizitätsmodul wird durch diese Behandlung wesentlich angehoben.

Es ist allgemein bekannt, derartige Flexodruckformen dadurch herzustellen, daß man den mit dem Fotoelastomer beschichteten Zylinder durch einen darübergelegten und rund um den Hohlzylinder gespannten Großfilm mit einer UV-Lichtquelle belichtet und die nichtbelichteten Stellen des Fotoelastomers, anschließend in einem Lösemittelbad auswäscht und auf diese Weise entwickelt. Anstelle des um den Hohlzylinder gelegten Großfilms kann auch ein tangential an den Zylinder gelegter und mit dessen Oberfläche synchron bewegter Film verwendet werden.

Beide Verfahren haben jedoch Nachteile. So muß in beiden Fällen ein sehr genau angefertigter Zylinder und ein ebenso genau gefertigter Film verwendet werden. Anderenfalls kommt es an der Umfangsstoßstelle des Films zu einem freibleibenden Spalt oder zu einer Überlagerung des Musterbildes und somit zu entsprechenden Fehlern in der Gravur.

Bei einer bekannten Vorrichtung zum Herstellen von lithografischen Druckplatten (EP-A-0 503 621) ist eine Tintenstrahl-Beschichtungs- und Belichtungsstation vorgesehen, der lithografische Druckplatten zugeführt werden. In der Beschichtungs- und Belichtungsstation wird die lithografische Platte auf eine Trommel aufgezogen und mit ihren in Transportrichtung, also in Umfangsrichtung der Trommel gesehen vorderen und hinteren Kanten auf der Trommel festgeklemmt. Mit Hilfe derTrommel wird die lithografische Druckplatte zunächst an einer Tintenstrahldüse, die ein gewünschtes Muster zeilenförmig auf die Druckplatte aufspritzt, und anschließend an einer Belichtungsstation vorbeigeführt, um danach von der Trommel abgenommen und in der üblichen Weise weiterbehandelt zu werden.

Die Tintenstrahldüse, die parallel zur Trommelachse verschiebbar angeordnet ist, ist dabei als Einfach- oder Mehrfachdüse ausgebildet, wobei die Mehrfachdüse mehrere in einer oder zwei Linien quer zur Verschieberichtung der Düse, also quer zur Trommelachse angeordnete Einzeldüsen aufweist. Sind zwei in Verschieberichtung der Düse nebeneinander liegende Reihen oder Spalten von Einzeldüsen vorgesehen, so sind die Einzeldüsen der beiden Reihen oder Spalten gegeneinander versetzt, sodass jede der Einzeldüsen eine eigene Musterlinie parallel zur Trommelachse beschreibt. Hierdurch lässt sich der Abstand der Einzeldüsen quer zur Zeilen- bzw. Verschieberichtung der Mehrfachdüse verringern, sodass auch der Abstand der einzelnen Musterlinien quer zur Zeilenrichtung verringert werden kann.

Bei einer anderen bekannten Vorrichtung (GB-A-732 435) zum Aufbringen eines flüssigen Beschichtungsmaterials auf einen Zylinder ist eine einzelne Sprühdüse vorgesehen, die parallel zur Längsachse des Zylinders verschoben werden kann, während sich der Zylinder um seine Zylinderachse dreht.

Der Erfindung liegt die Aufgabe zugrunde, eine Vorrichtung zum Aufbringen einer Abdeckflüssigkeit auf einen Zylinder bereitzustellen, mit der insbesondere die Herstellung von Flexodruckformen ohne Verwendung von Großfilmen möglich ist.

Diese Aufgabe wird durch die Vorrichtung nach Anspruch 1 gelöst.

Vorteilhafte Ausgestaltungen und Weiterbildungen der Erfindung sind in den nachgeordneten Unteransprüchen beschrieben.

Mit der erfindungsgemäßen Vorrichtung lässt sich also eine Abdeckflüssigkeit durch mehrere Düsen auf einen Träger, zum Beispiel eine Fotoelastomerschicht für eine Flexodruckform aufspritzen. Dabei kann das Aufspritzen der Abdeckflüssigkeit auf einen Zylinder und bei Drehung des Zylinders um seine Zylinderachse sowie unter Verschiebung der Düsen parallel zur Zylinderachse erfolgen. Dabei werden die Drehlage des Zylinders und die Düsenstellung in Achsrichtung ständig registriert, um Positionen auf der Zylinderoberfläche bestimmen zu können, an denen in Übereinstimmung mit einem gewünschten Muster Abdeckflüssigkeit aufgespritzt werden soll oder nicht. Durch den genannten Aufspritzvorgang lassen sich mit der erfindungsgemäßen Vorrichtung die Muster sehr exakt und in kurzer Zeit herstellen, wozu die Düsen entsprechend elektronisch angesteuert werden können. Die Drehrichtung des Zylinders und die Düsenstellung können dabei so gewählt sein, daß die Relativgeschwindigkeit zwischen der Zylinderoberfläche und der Abdeckflüssigkeit beim Aufspritzen möglichst klein ist, um ein Zerspritzen der Abdeckflüssigkeitstropfen beim Auftreffen auf die Zylinderoberfläche zu verhindern.

Mit anderen Worten läßt sich mit der erfindungsgemäßen Vorrichtung die zur Erzeugung des Musters erforderliche Abdeckflüssigkeit auf den mit noch unvernetztem Fotoelastomer beschichteten Träger auftragen, und zwar nur an jeden Stellen, die bei dem späteren Druckprozeß keine Druckfarbe übertragen sollen. Es wird also mit der Abdeckflüssigkeit ein Negativbild auf der Oberfläche der Fotoelastomerschicht erzeugt. Dabei kommt man mit einem Minimum an Abdeckflüssigkeit aus, so daß sich das Muster relativ kostengünstig auftragen läßt. Großfilme brauchen nicht mehr hergestellt und relativ zum Träger positioniert zu werden, wie im konventionalen Fall, so daß mit der erfindungsgemäßen Vorrichtung auch ausgesprochen umweltfreundlichen und zeitsparend gearbeitet werden kann.

Bei einer vorteilhaften Weiterbildung der Erfindung liegen die Düsen mit ihrer Düsenlängsachse im wesentlichen vertikal, so daß die Abdeckflüssigkeit unter einer Richtung aus den Düsen ausgespritzt wird, die wenigstens annährend parallel zur Erdanziehungskraft verläuft.

Um eine zuverlässige, insbesondere UV-lichtundurchlässige Abdeckung des Fotoelastomers zu erreichen, ist bei der erfindungsgemäßen Vorrichtung vorgesehen, daß die Düsen zur Ausspritzung einer Metallpigmente enthaltenden Abdeckflüssigkeit, insbesondere einer Silberhalogenidemulsion, vorzugsweise einer Silberbromid, Silberjodid und/oder Silberchlorid in Gelatine oder Polyvenylalkohohl enthaltenden Abdeckflüssigkeit geeignet sind. Auf diese Weise lassen sich auch sehr fein vermahlte Metallpigmente enthaltende Abdeckflüssigkeiten einsetzen, um auch sehr feine Strukturen übertragen zu können.

Kommen als Düsen beispielsweise elektrostatische Düsen zum Einsatz, so wird ein teilweise elektrostatisch aufgeladener Tropfennebel erzeugt, wobei die elektrisch aufgeladenen Tropfen aus ihrer Flugbahn abgelenkt und von den nichtgeladenen Tropfen auf diese Weise separiert werden. Die Tropfen unterliegen hierbei den Einflüssen der Schwerkraft und des Luftwiderstandes und beschreiben daher parabolische Bahnkurven während ihrer Bewegung durch die Düse. Wenn die Anfangsgeschwindigkeit des Flüssigkeitsstrahles, aus welchem die Tropfen entstehen, immer auf einen konstanten und gleichen Wert gehalten werden kann, dann ist eine parabolische Flugbahn nicht nachteilig. Muß aber mit Rücksicht z. B. aufrheologische Parameter der Abdeckflüssigkeit oder die einwandfreie Bedeckung des Zylinders eine andere Anfangsgeschwindigkeit vorgegeben werden, so resultiert hieraus auch eine andere Bahnparabel und die Selektion der unterschiedlich geladenen Tropfen wird schwieriger. Diese Verhältnisse können einheitlicher gestaltet werden, wenn die Bahnrichtung der Tropfen senkrecht gewählt wird, also die Düsenachse vertikal steht und die Düsen z. B. von oben nach unten die Abdeckflüssigkeit auf den Zylinder aufbringen. Auf diese Weise wird erreicht, daß die Bahn der Tropfen zunächst unbeeinflußt von der Schwerkraft bleibt und die Tropfen daher genau durch das Zentrum einer vor dem Ausspritzkanal liegenden Ringelektrode zur elektrostatischen Aufladung hindurchlaufen können, bevor sie schließlich durch eine nachfolgende Ablenkelektrode abgelenkt werden. Im Gegensatz dazu wird bei horizontalen Düsen die Tropfenbahn schon unmittelbar hinter dem Ausspritzkanal durch Schwerkraft beeinflußt, so daß es schwieriger ist, das Zentrum der Ringelektrode zu treffen.

Es hat sich als vorteilhaft erwiesen, das Aufspritzen der Abdeckflüssigkeit unter Begleitung eines sie umgebenden, laminaren Gasstromes vorzunehmen, beispielsweise unter Verwendung eines Luft- oder Inertgasstromes, um den Trocknungsvorgang der ausgespritzten Abdeckflüssigkeit zu beschleunigen. Der Gasstrom verhindert darüber hinaus, daß sich kleine Sekundärtröpfchen im Innern der Düse anlagern und diese ansonsten verschmutzen würden. Außerdem kann die Geschwindigkeit des laminaren Gasstroms so gewählt werden, daß sich einmal gebildete Tropfen auf ihrem Weg zum Träger bzw. Zylinder nicht mehr einander nähern können, wodurch die Bildung größerer Tropfen vermieden wird. Ferner kann der laminare Gasstrom auch gegenüber der Umgebungstemperatur eine erhöhte Temperatur aufweisen, wodurch sich das Trocknen der ausgespritzten Abdeckflüssigkeit noch weiter beschleunigen läßt. Nicht zuletzt kann der Zylinder wenigstens auch im Auftreffpunkt der Abdeckflüssigkeit beheizt werden, beispielsweise durch einen Wärmestrahler, um möglichst schnell eine feste Abdeckschicht auf der Zylinderoberfläche bzw. Oberfläche der Fotoelastomerschicht zu erhalten.

Diese Düse empfängt elektrische Ausspritzsignale von der Steuereinrichtung, und zwar in Übereinstimmung mit einem vorgegebenen Muster sowie in Abhängigkeit der Drehstellung des Zylinders und der Position des Bearbeitungstisches. Das Muster bzw. Druckmuster kann dabei in elektronischer Form in einem Elektronikspeicher der Steuereinrichtung vorgespeichtert sein. Dabei ist jedem gespeicherten Musterpunkt ein Wertepaar zugeordnet, das die Drehstellung des Zylinders (Winkelstellung) und die Axialposition des Bearbeitungstisches enthält. Sobald dieses Wertepaar durch Sensoren zur Steuereinrichtung geliefert wird, wird der zugeordnete Wert des Druckmusters aus dem genannten Elektronikspeicher ausgelesen und zur Bildung eines Ausspritzsignals herangezogen, das zur Düse übertragen wird.

Die Erfindung wird nachfolgend unter Bezugnahme auf die Zeichnung näher beschrieben. Es zeigen:
**Figur 1** eine Vorrichtung nach einem ersten Ausführungsbeispiel zum Aufbringen einer Abdeckflüssigkeit auf die Oberfläche eines Zylinders,
**Figur 2** eine Vorrichtung nach einem zweiten Ausführungsbeispiel zum Aufbringen der Abdeckflüssigkeit auf die Oberfläche eines Zylinders,
**Figur 3** Aufbau und Anordnung einer ersten Düse zum Aufspritzen von Abdeckflüssigkeit,
**Figur 4** den detaillierten Aufbau der ersten Düse,
**Figur 5** Aufbau und Anordnung einer zweiten Düse zum Aufspritzen von Abdeckflüssigkeit,
**Figuren 6 bis 8** den detaillierten Aufbau der zweiten Düse und
**Figur 9** einen Querschnitt durch den Zylinder.

Nachfolgend werden verschiedene Ausführungsbeispiele der Erfindung im einzelnen unter Bezugnahme auf die Zeichnung näher beschrieben.

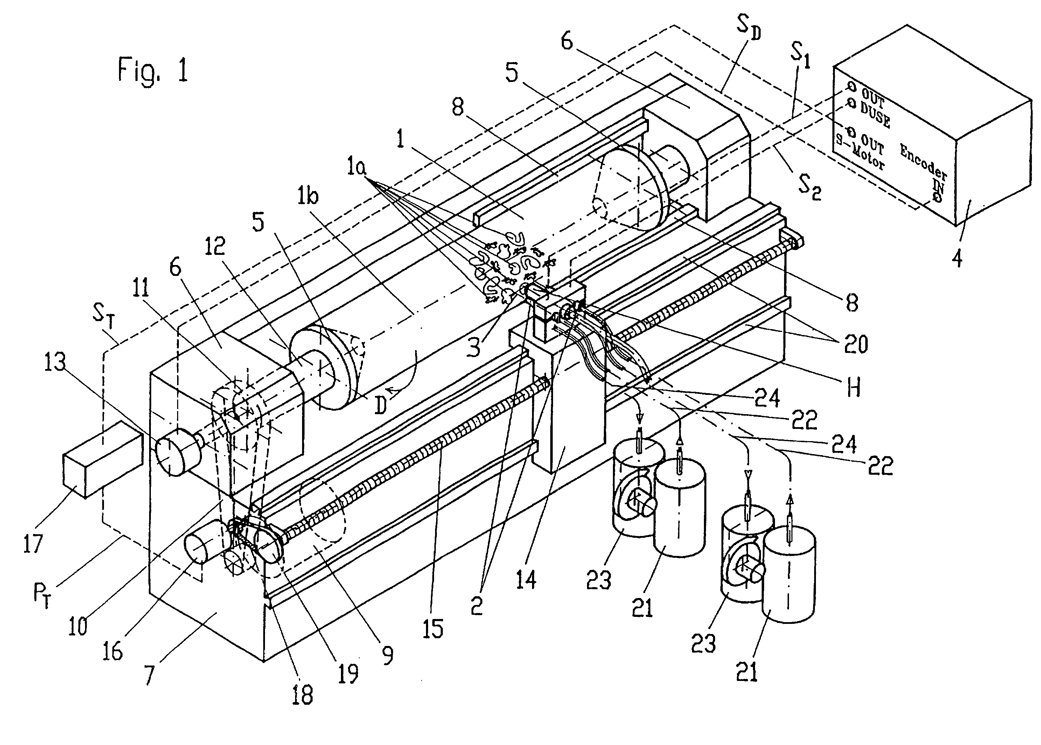

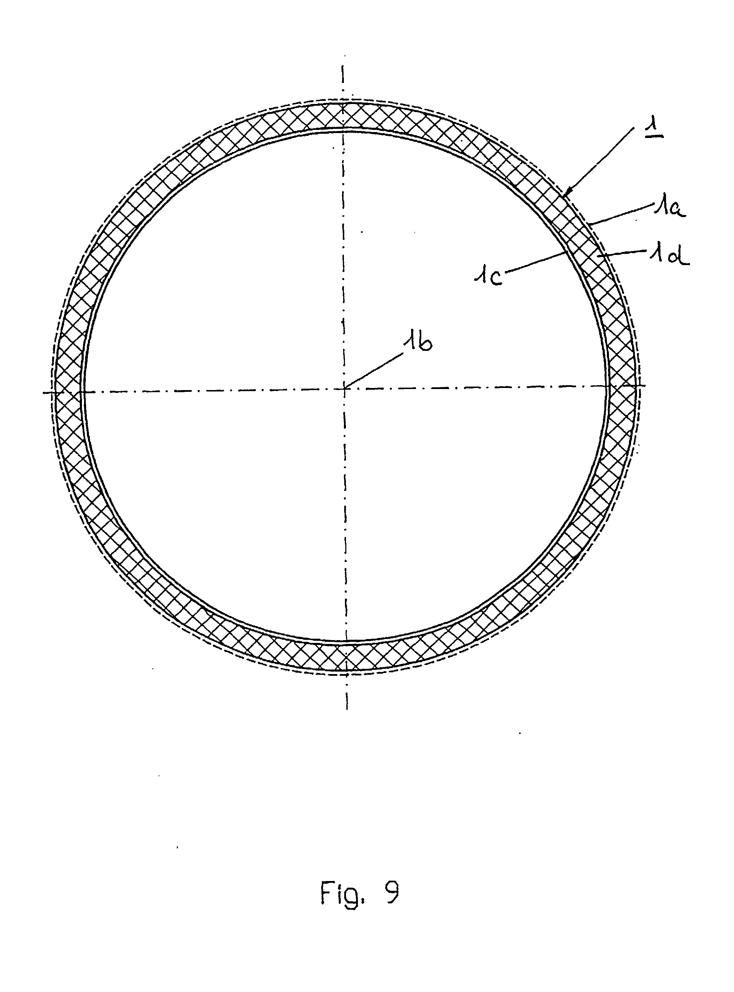

Ein erstes Ausführungsbeispiel einer erfindungsgemäßen Vorrichtung zeigt die Figur 1. Mit dem Bezugszeichen 1 ist ein Fotopolymerzylinder 1 bezeichnet, auf dessen Umfangsfläche ein Muster 1a aufgespritzt wird. Der Zylinder 1 rotiert um seine Zylinderachse 1b und besteht aus einem inneren Hohlzylinder 1c aus z. B. Nickel, der auf seiner Oberfläche mit Fotoelastomer 1d beschichtet ist, auf welchem das Muster 1a zu liegen kommt. Dies ist in Figur 9 dargestellt.

Durch mehrere Düsen 2 wird Farbe oder Lack als Abdeckflüssigkeit aufgespritzt. Hierbei wird ein aus den Düsen 2 ausgespritzter Strahl 3 der Abdeckflüssigkeit mittels eines Rechners 4 so gesteuert, daß die Abdeckflüssigkeit nur an jenen Stellen auf den Zylinder 1 aufgebracht wird, an welchen dieser musterbedingt unvernetzt bleiben muß und jene Stellen des Zylinders 1 unbedeckt bleiben, an welchen die Fotopolymeroberfläche des Zylinders 1 im nachfolgenden Verfahrensschritt vernetzt werden soll. Der Zylinder 1 wird zu diesem Zweck zwischen zwei synchron angetriebenen Endköpfen 5 aufgenommen und in drehende Bewegungversetzt, wobei die Drehrichtung mit D bezeichnet ist.

Um verschiedene Schablonen- bzw. Zylinderlängen zwischen den Endköpfen 5 aufnehmen zu können, ist beispielsweise der rechte Endkopf 5 in Richtung der Zylinderachse 1b des Zylinders 1 verschiebbar. Der Zylinder 1 wird zwischen den rechten und den linken Endkopf 5 gelegt und der rechte Endkopf 5 an den Zylinder 1 herangefahren. Der üblicherweise ausreichend leicht gestaltete Zylinder 1 kann unter Umständen auch schon durch die axial wirkende Spannkraft und die Reibung zwischen dem Zylinder 1 und dem linken angetriebenen Endkopf 5 in Drehung versetzt werden. Auch reicht die Steifigkeit des Zylinders 1 immer aus, um auch dem rechten Endkopf 5 über die wirkenden Reibkräfte die Drehbewegung mitzuteilen, wenn nur die Drehzahl des Zylinders 1 so langsam erhöht wird. daß das erforderliche Beschleunigungsmoment die Übertragungsfähigkeit des Zylinders 1 nicht überfordert. Beide Endköpfe 5 sind an Lagerböcken 6 drehbar montiert, wobei die Lagerböcke 6 auf einem Maschinenbett 7 angeordnet sind. Zur Führung des rechten Lagerbocks 6 in Figur 1 sind Führungsstangen 8 vorhanden, die z. B. auf dem Maschinenbett 7 befestigt sein können.

Der linke Endkopf 5 wird durch einen Motor 9 und einen Riemen 10 angetrieben. Dieser Riemen 10 umspannt ein Antriebsrad 11, das fest auf einer Achse 12 liegt, welche den linken Endkopf 5 trägt. Am anderen Ende der Achse 12 befindet sich ein inkrementaler Impulsgeber 13, der die Drehlage der Achse 12 bzw. des Zylinders 1 bestimmt und entsprechende Signale S_{D} an den Rechner 4 abgibt. Gleichzeitig werden die Düsen 2, die auf einem Bearbeitungstisch 14 befestigt sind, in Richtung der Zylinderachse 1b des Zylinders 1 langsam vorgeschoben, so daß ein dünner in Tropfen aufgelöster und aus Abdeckflüssigkeit bestehender Strahl, der aus den Düsen 2 austritt, entlang einer Schraubenlinie sehr geringer Steigung auf den Zylinder 1 auftrifft. Dem Bearbeitungstisch 14 wird seine Vorschubbewegung über eine Spindel 15 aufgeprägt, wobei diese Spindel 15 hierzu über einen Schrittmotor 16 angetrieben wird, der seine Schritt-Signale S_{T} ebenfalls vom Rechner 4 empfängt. Diese Schritt-Signale S_{T} werden durch eine Treiberstufe 17 in Leistungsimpulse P_{T} umgesetzt. Die Drehung der Motorachse des Schrittmotors 16 wird über einen Riemen 18 und eine Riemenscheibe 19 auf die Spindel 15 übertragen. Diese durchragt den Bearbeitungstisch 14, der seinerseits auf Führungsschienen 20 am Maschinenbett 7 geführt ist.

Die Düsen 2 müssen mit einer für den späteren UV-Belichtungsvorgang geeigneten Abdeckflüssigkeit versorgt werden. Hierzu sind sie mit kleinen Druckbehältern 21 über Versorgungsleitungen 22 verbunden. In den Druckbehältern 21 steht die Abdeckflüssigkeit unter einem geringen Überdruck von etwa 1 bis 5 bar. Zweckmäßigerweise wird man für jede Düse 2 einen getrennten Druckbehälter 21 vorsehen, da Unterschiede in den Leitungswiderständen und die Notwendigkeit, die Auftragsmenge je Düse 2 getrennt einregeln zu können, unterschiedliche Ausgangsdrucke der Abdeckflüssigkeit bedingen. Es fällt bei jeder Düse 2 auch eine nicht unbeträchtliche Menge unverbrauchter Abdeckflüssigkeit an, die kontinuierlich abgesaugt und zurückbefördert werden muß. Hierzu sind Unterdrucktanks 23 vorgesehen, in welche über Rückleitungen 24 die unverbrauchte Abdeckflüssigkeit durch den in diesen Tanks herrschenden Unterdruck zurückbefördert wird. Die rezirkulierte Abdeckflüssigkeit, welche auf Grund des durchlaufenen Prozesses Verdünnungsmittel verloren hat, kann nach einer Aufbereitung wiederum dem Auftragsprozeß als Abdeckflüssigkeit zugeführt werden. Die Trocknung der Abdeckflüssigkeit kann durch Aufblasen von Warmluft unterstützt werden, oder durch Erzeugung entsprechender Wärmestrahlung. Hierzu kann auf dem Bearbeitungstisch 14 eine entsprechend ausgebildete Heizeinrichtung H montiert sein.

Die Düsen 2 sind vorzugsweise als Elektrostatikdüsen ausgebildet, denen jeweils ein Steuersignal S₁, S₂ vom Rechner 4 zugeführt wird, um bei Empfang eines Steuersignals die Abdeckflüssigkeit auszuspritzen.

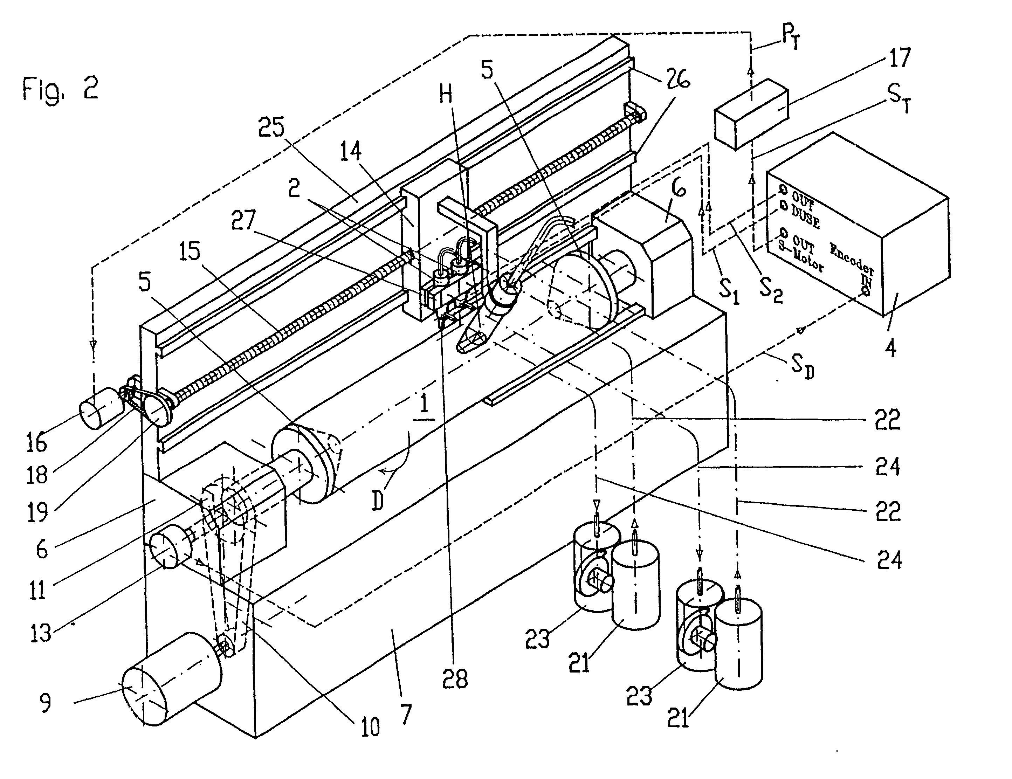

Die Figur 2 zeigt eine im Prinzip gleiche Vorrichtung wie in Figur 1, wobei gleiche Elemente mit den gleichen Bezugszeichen versehen sind. Abweichend von Figur 1 ist hier der Bearbeitungstisch 14 aber an einer hinteren Trägerwand 25 auf Führungsschienen 26 in Axialrichtung des Zylinders 1 verschiebbar gelagert. An dieser hinteren Führungswand 25 sind ebenfalls die Spindel 15 und der Schrittmotor 16 mit Spindelantrieb 18 und 19 befestigt. An der dem Zylinder 1 zugwandten Vorderseite des Bearbeitungstisches 14 befindet sich eine Halteeinrichtung 27, die zum Festklemmen zweier Düsen 2 dient, welche nunmehr mit ihren Düsenachsen vertikal stehen, also senkrecht zur ebenen Oberfläche des Maschinenbettes 7. Die Düsenöffnungen 28 weisen dabei nach unten.

Auf diese Weise ist es möglich, die Tropfen des Abdeckmaterials zunächst parallel zur und in Gravitationsrichtung auszuspritzen, bevor sie auf die Oberfläche des Zylinders 1 auftreffen.

Bei der Erfindung wird die Abdeckflüssigkeit in feinsten Tropfen aufgebracht werden, um ein hinreichend hohes Auflösungsvermögen bei der Erzeugung des Druckmusters auf der Oberfläche des Zylinders 1 zu erzielen. Dabei weist die Flüssigkeit eine hohe Viskosität auf, um einen ausreichenden Anteil von Festsubstanz (Gelantine, Polyvinylalkohol) und Abdecksubstanz (z. B. Metallpigmente, Silberhalogenide) bei relativ kleiner Tropfengröße mitführen zu können. Darüber hinaus erfolgt das Aufspritzen der Abdeckflüssigkeit mit einer sehr hohen Tropfenfrequenz.

Dies alles ist möglich durch den Einsatz sogenannter elektrostatisch wirkender Düsen, bei welchen ein Flüssigkeitsstrahl durch eine sehr hochfrequente Schwingung, beispielsweise einer Rohrwand, regelmäßig in Tropfen zerfallen gelassen wird und bei welchen die Tropfen anschließend elektrisch geladen werden und in einem Elektrostatikfeld je nach Ladungszustand abgelenkt oder nicht abgelenkt werden. Herkömmliche Düsen dieser Art sind jedoch nicht geeignet, die für das Beschichten von Zylindern erforderlichen hochviskosen Abdeckflüssigkeiten zu verarbeiten. Während bei niederviskosen Flüssigkeiten bereits geringe Anfangsstörungen genügen, um den Flüssigkeitsstrahl durch die Wirkung der Oberflächenspannung der Flüssigkeit unmittelbar hinter dem Düsenaustritt rasch in Einzeltropfen zerfallen zu lassen, würden bei den für die Schablonenabdeckung notwendigen hohen Viskositäten Strahllängen von 0,5 - 1,0 m entstehen, bevor der erste Tropfen durch Strahleinschnürung entsteht. An der Stelle der ersten Tropfenbildung muß eine ringförmige Ladeelektrode mit sehr kleinem Durchmesser angeordnet werden. Auf Grund der unvermeidlichen Luftwirbel ist bei solchen Abständen weder der Ort der ersten Tropfenbildung genau festlegbar noch der Verlauf des Strahles, so daß durch eine so kleine ringförmige Ladeelektrode nicht mehr hindurchgetroffen werden kann. Bei der Erfindung kommen daher Elektrostatikdüsen mit geänderter Bauweise zum Einsatz.

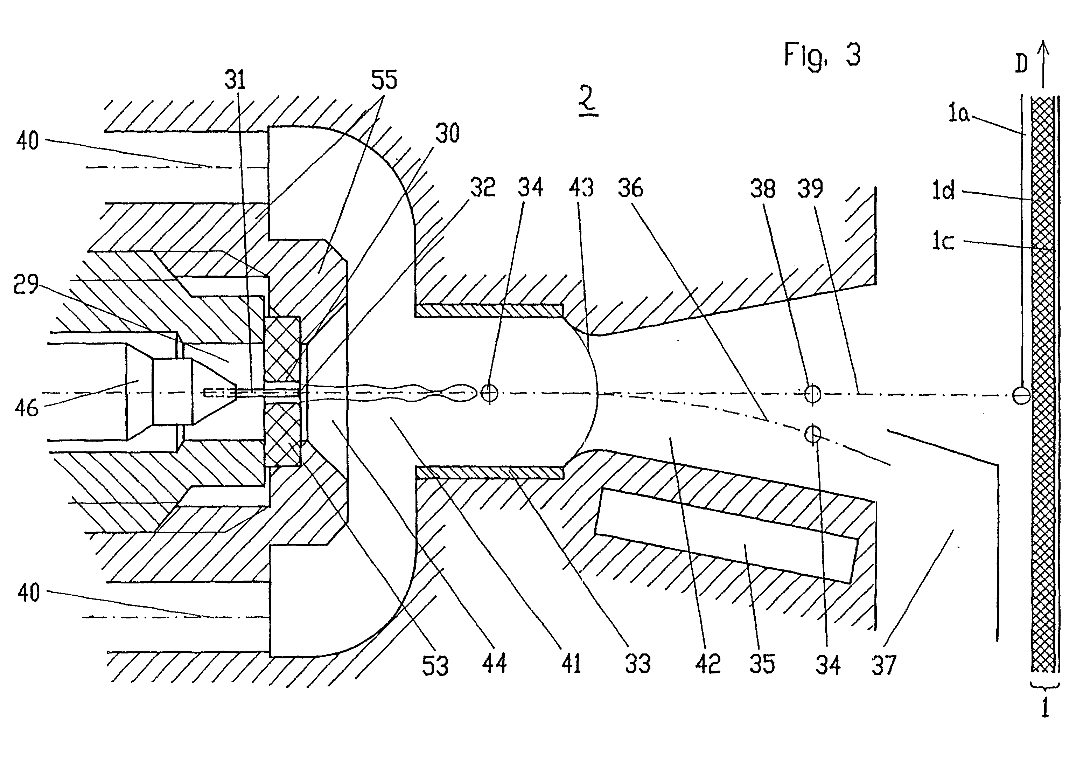

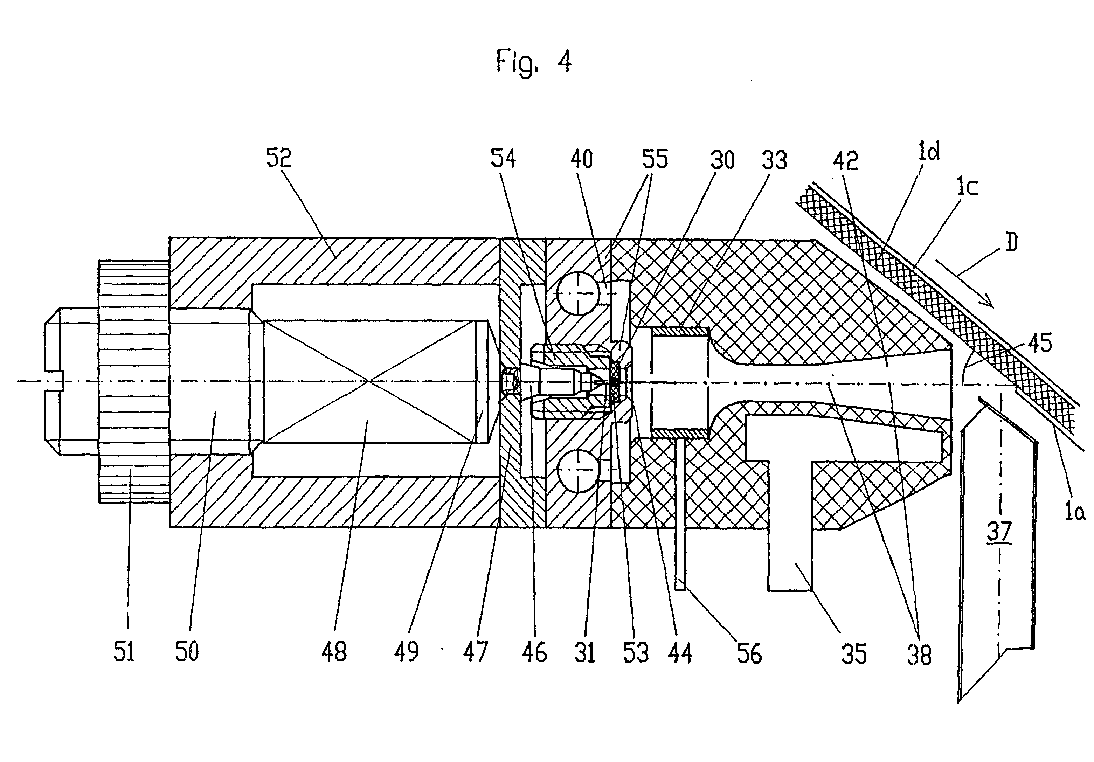

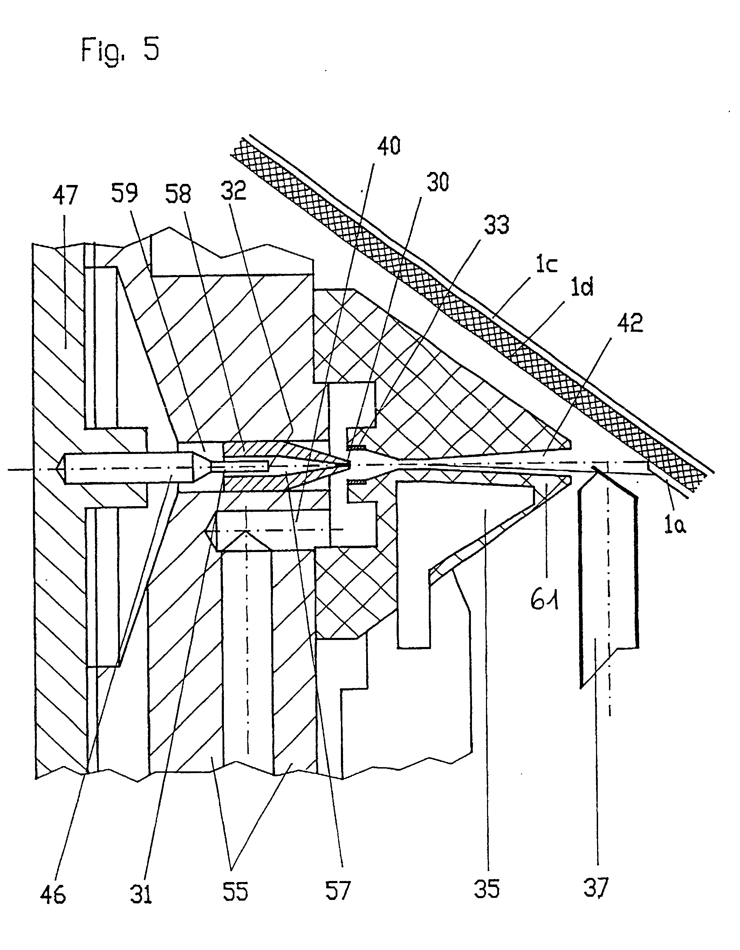

Die Figur 3 zeigt den Aufbau einer derartigen Elektrostatikdüse 2.

In einer kleinen Druckkammer 29 steht die Abdeckflüssigkeit, die aus den in Figur 1 gezeigten Druckbehältern 21 herangeführt wird, unter Überdruck. Von dort tritt sie kontinuierlich durch eine Bohrung 30 aus. In der Bohrung 30 sorgt eine dünne Nadel 31, die durch Ultraschall zu hochfrequenter Schwingung in Nadellängsrichtung angeregt wird, für regelmäßige Störungen in jenem ringförmigen Strömungskanal, der durch die Nadel 31 und die Bohrung 30 gebildet wird. Außerdem verhindert die Schwingungsbewegung der Nadel 31 auch ein Verstopfen der Bohrung 30 z. B. durch kleine Partikel. Bei jeder Schwingungsbewegung der Nadel 31 in Richtung des Austritts, zu welchem die Abdeckflüssigkeit auf Grund des Druckgefälles strömt, wird die Abdeckflüssigkeit zufolge ihrer Zähigkeit mit der Nadelwand mitgenommen und so zusätzlich beschleunigt und bei jeder entgegengesetzt gerichteten Schwingungsbewegung wird sie auf die gleiche Weise verzögert. Auch die Bewegung der Stirnfläche 32 der Nadel 31 erbringt einen in der Wirkung gleichgerichteten Effekt. Diese Stirnflächenbewegung der Nadel 31 ist bei den hier vorliegenden Suspensionen von kleinen Pigmenten oder Kristallen in zäher Flüssigkeit von besonderem Vorteil, da bei entsprechend hohen Beschleunigungswerten der Stirnfläche 32 die Festkörperchen abgeschleudert werden, was zu einer besonders starken Unterstützung des Einschnürvorgangs führt. Man hat es durch Dimensionierung des Durchmessers der Nadel 31 und der Bohrung 30 in der Hand, die Beschieunigungs- bzw. die Verzögerungseffekte ausreichend groß zu gestalten. Je größer der Durchmesser der Nadel 31 und je kleiner der Durchmesser der Bohrung 30 sind, desto stärker sind die Beschleunigungs- und damit die Störungseffekte. Aus den so herbeigeführten starken Störungen ergeben sich ausgeprägte, der Schwingungsfrequenz entsprechende regelmäßige Einschnürungen des die Bohrung 30 verlassenden Flüssigkeitsstrahls, die außerhalb der Bohrung 30 zufolge der Oberflächenspannung der Flüssigkeit weiter fortgebildet werden und so zu einer raschen Tropfenbildung führen. Damit die entstandenen Tropfen elektrostatisch aufgeladen werden können, ist eine Ringelektrode 33 vorgesehen, die im Durchmesser kleingehalten wird, weil dann schon bei niedrigen Spannungen eine ausreichende Aufladung der Tropfen erreicht werden kann. Es wird angestrebt, mit einer Spannung von 100 - 200 V arbeiten zu können. Diese Spannung muß im Augenblick des Tropfenabrisses an der Ringelektrode 33 anliegen. Spannungen dieser Größe lassen sich noch bequem mit hohen Frequenzen durch Transistoren schalten. Zum Zeitpunkt des Abrisses des Tropfens vorn noch zusammenhängenden Strahl muß dieser auf einem 0 - Spannungspotential gegenüber der Ringelektrode 33 gehalten werden, damit auf dem abreißenden Tropfen eine negative Ladung verbleibt, und außerdem muß der Abriß im Bereich der Ringelektrode 33 erfolgen. Für die elektrische Verbindung mit der Druckkammer 29, die dauernd auf Erdpotential (= O V) gehalten wird, muß die innere Leitfähigkeit der Abdeckflüssigkeit sorgen. Daher ist es äußerst zweckmäßig, für die Abdeckflüssigkeit eine wässrige Suspension von Kristallen oder eine wässrige Suspension von Pigmenten zu wählen. Die Ringelektrode 33 wird im Durchmesser kleingehalten, wodurch hohe Feldstärken bereits bei niedrigeren Schaltspannungen erreicht werden. Damit der aus der Bohrung 30 austretende Flüssigkeitsstrahl das Zentrum der Ringelektrode 33 mit möglichst großer Sicherheit trifft, wird diese Ringelektrode 33 so nahe wie möglich an den Austritt der Bohrung 30 herangeführt. Der Strahl muß an dieser Stelle gerade beginnen, in Tropfen zu zerfallen. Die Treffsicherheit des Ringelektrodenzentrums wird durch eine vertikale Strahlführung, wie bereits im Zusammenhang mit der Figur 2 erwähnt, wesentlich vergrößert, wobei für den notwendigen raschen Strahlzerfall entsprechend stark ausgeprägte Anfangseinschnürungen des aus der Bohrung 30 austretenden Flüssigkeitsstrahles sorgen, die durch eine entsprechend starke Schwingung der Nadel 31 erzwungen werden.

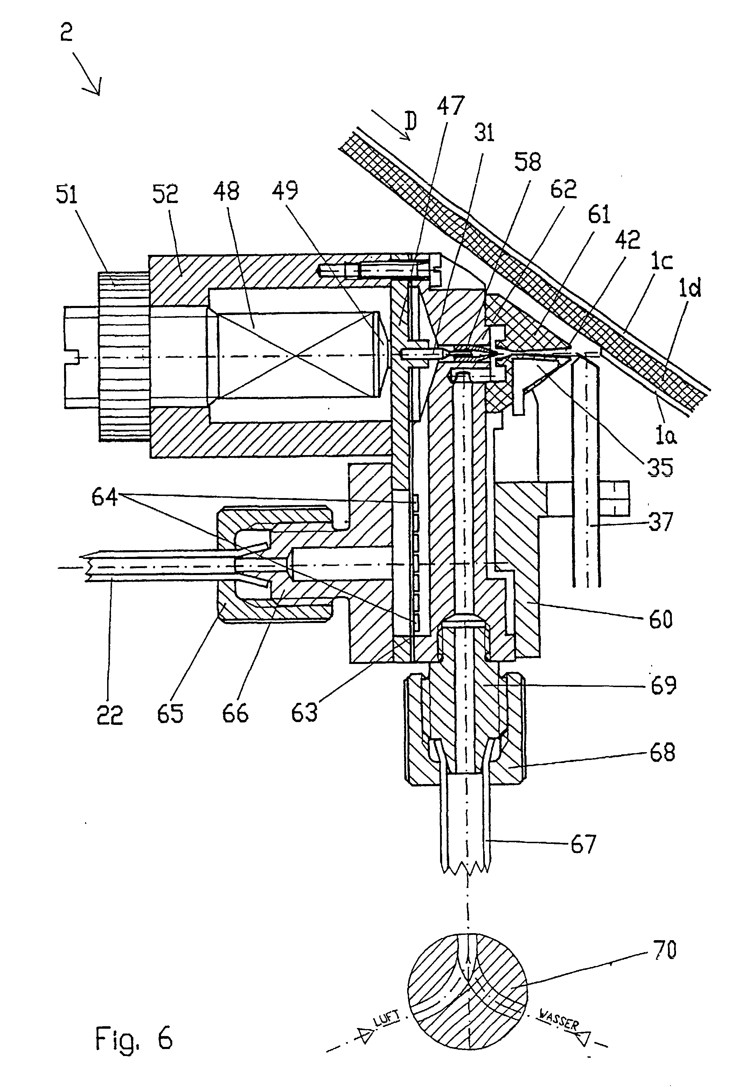

Die aufgeladenen Flüssigkeitstropfen, die hier das Bezugszeichen 34 tragen, werden anschließend durch die Wirkung eines über eine Elektrode 35 aufgebrachten Gleichspannungsfeldes auf einer gekrümmten Bahnlinie 36 in einen Fänger 37 geleitet. Von dort gelangen sie über die in Figur 1 erwähnten Rückleitungen 24 in die ebenfalls dort gezeigten Unterdrucktanks 23. Die nichtgeladenen Flüssigkeitstropfen 38 werden durch dieses Gleichspannungsfeld nicht abgelenkt und entsprechend setzen diese ihren Weg nahezu geradlinig entlang der Bahnlinie 39 fort, um schließlich auf den Zylinder 1 zu treffen. Der Zylinder 1 weist hier eine zur Bahn 39 der auf dieses auftreffenden, ungeladenen Tropfen 38 senkrechte Lage auf. Es kann aber durchaus zweckmäßig sein, den Zylinder 1 gegenüber einer solchen Lage zu neigen, was im Zusammenhang mit der nächsten Figur 4 gezeigt wird. Die Abdeckflüssigkeit muß in ausreichendem Maße Feststoffe transportieren, um nach Eintrocknen auf dem Zylinder 1 einen gut lichtabdeckenden Film zu bilden. Dies bedingt eine hohe Viskosität. Die hohe Zähigkeit hilft ferner, daß nach der Aufbringung der Abdeckflüssigkeit auf dem Zylinder 1 diese trotz der wirkenden Fliehkraft am Auftreffort verbleibt und auch nicht auf Grund der hohen Auftreffgeschwindigkeit in noch kleinere Tröpfchen zerspritzt.

Damit die Ringelektrode 33 auch während langer Betriebszeiten sauber bleibt, wird eine kombinierte Flüssigkeits- und Luft- oder Inertgaszufuhr in den Bereich der Ringelektrode 33 durchgeführt. Knapp vor Beginn des Spritzbetriebs wird durch Bohrungen 40 zunächst Flüssigkeit eingeleitet, um die Ringelektrode 33 zu reinigen. Anschließend wird diese durch die gleichen Bohrungen 40 trocken geblasen, etwa durch trockene, erwärmte Luft oder ein Inertgas. Die gleiche Ausgestaltung der Düse wird zusätzlich genutzt, um ein Eintrocknen der dünnen Bohrung 30 während längerer Arbeitspausen zu verhindern. In diesem Fall wird durch die Bohrungen 40 der anschließende Luftraum 41 vor der Bohrung 30 und innerhalb der Ringelektrode 33 mit Spülflüssigkeit gefüllt. Diese Spülflüssigkeit wird unter einem sehr geringen Überdruck gehalten (etwa 10 bis 20 mm Wassersäule), wodurch sich noch innerhalb des Düsenkanals 42 ein Flüssigkeitsmeniskus 43 ausbildet, der über längere Zeit bestehen kann, und der ein Austreten von Flüssigkeit aus dem Düsenkanal 42 verhindert. Diese Befüllung schützt die dünne Bohrung 30 vor dem Eintrocknen. Um der Flüssigkeit einen möglichst guten Zutritt zu der Bohrung 30 zu ermöglichen, kann eine kegelförmige Ansenkung 44 vorgesehen ein. Durch sie öffnet sich die Bohrung 30 in den Düsenkanal 42 in Richtung der Ringelektrode 33. Es kann aber auch zweckmäßig sein, die Spülflüssigkeit nicht in Kontakt mit der Abdeckflüssigkeit innerhalb der Bohrung 30 treten zu lassen, um letztere nicht zu verdünnen. In diesem Fall entfällt die konische Ansenkung 44, und es findet sich an dieser Stelle nur ein entsprechend klein gehaltener zylindrischer Bohransatz. Die Spülflüssigkeit wird dann auch in dieser Bohrung einen Meniskus bilden, ähnlich dem Meniskus 43. Einen ebensolchen bildet die Abdeckflüssigkeit am Ausgang der Bohrung 30. Zwischen beiden Menisken befindet sich dann ein kleiner Luftraum, der dank seines kleinen Volumens rasch mit dampfförmigen Molekülen der leicht abdampfbaren Komponenten des Abdecklackes und der Spülflüssigkeit gesättigt wird. Eine weitere Abdunstung dieser Komponenten aus dem Abdecklack ist dann nicht mehr möglich, so daß ein Eintrocknen verhindert wird, ohne die Gefahr, daß die Abdeckflüssigkeit durch Spülflüssigkeit vedünnt wird.

Die Düse 2 wird auch während der Ausbringung von Abdeckflüssigkeit auf den Zylinder 1 von Luft durchströmt. Dadurch hält die aus den Bohrungen 40 austretende Trockenluft kleine Sekundärtröpfchen von der Ringelektrode 33 ab und diese somit sauber. Solche Sekundärtröpfchen entstehen gleichzeitig mit den Haupttropfen bei dem Zerfall des aus der Bohrung 30 austretenden Flüssigkeitsstrahls. Wegen der Kleinheit und der geringen Masse dieser Sekundärtröpfchen können diese durch den Abschnürungsvorgang der Haupttropfen an die Ringelektrode 33 geschleudert werden. Würden sich dort Tropfenansätze bilden, dann könnte mit der Zeit die einwandfreie Funktion der Elektrode in Frage gestellt werden. Ein weiterer Effekt ergibt sich bei der Durchströmung des diffusorartigen Kanals 42.

Hier sollte die Fluggeschwindigkeit der Tropfen zwar etwas aber nicht zu stark verzögert werden, da sich diese erst nach dem Auftreffen auf dem Sieb 1 berühren dürfen. Eine Berührung der Flüssigkeitstropfen noch innerhalb des Düsenkanals 42 würde zur sofortigen Bildung von großen Tropfen führen, die wiederum wegen des spezifisch geringeren Luftwiderstandes weitere Normal-Tropfen einfangen und in Summe führen diese Vorgänge zu einer Verfälschung des elektrisch aufgeprägten Musterbildes. Diese Erscheinung kann dann verhindert werden, wenn die Tropfen auf ihrer Flugbahn innerhalb des Düsenkanals 42 von einer laminaren Luftströmung eingehüllt werden, die eine hierzu geeignete Strömungsgeschwindigkeit aufweist. Durch eine solche und z. B. erwärmte Luftströmung kann auch eine Vortrocknung der Einzeltropfen erreicht werden. Dies bringt Vorteile, wenn der Tropfen auf den Zylinder 1 aufschlägt. Durch eine Vortrocknung läßt sich die Tropfenviskosität erhöhen und außerdem die Größe derTropfen verringern. Dadurch wird ein Zerplatzen der Tropfen in viele kleine Einzeltropfen beim Auftreffen auf den Zylinder 1 und die Ausbildung einer entsprechend unscharfen Lackkontur vermieden. Für eine ausreichende Vortrocknung ist allerdings eine verhältnismäßig große Länge des Düsenkanals 42 erforderlich, was insbesondere bei parallel zum Gravitationsfeld verlaufender Achse des Düsenkanals 30 möglich ist, also bei vertikaler Düsenachse.

Die Figur 4 zeigt den Gesamtaufbau der Düse nach Figur 3. Es gelten dabei die gleichen Bezugszeichen wie in Figur 3. Die Auftreffrichtung derTropfen 38 auf den Zylinder 1 ist hier nicht mehr senkrecht, sondern liegt unter einem Winkel 45. Dies hilft, die Tropfen mit vermindeter Relativgeschwindigkeit auf die Oberfläche des Zylinders 1 auftreffen zu lassen und so die Gefahr des Zerplatzens der Tropfen zu mindern und ein viskositätsabhängiges Fließen der Tropfen auf dieser Oberfläche zu unterdrücken. Die Nadel 31 ist in einem Nadelhalter 46 gefaßt, der als Stufenhorn ausgebildet ist, d. h. der Durchmesser des Nadelhalters 46 nimmt zur Spitze der Nadel 31 hin ab. Dies verstärkt die in den Nadelhalter 46 eingeleitete Amplitude der hochfrequenten mechanischen Schwingung, so daß die Nadel 31 im Bereich der Bohrung 30 mit maximalerAmplitude schwingt. Der Nadelhalter 46 ist fest in einer Membran 47 gefaßt und diese wird durch ein Piezoelement 48 zu der hochfrequenten Schwingung angeregt. Ein Druckstück 49 leitet diese Schwingung an die Membran 47 weiter, wodurch die in der Druckkammer 29 befindliche Flüssigkeit auch durch die Membran 47 selbst druckbeaufschlagt wird. Um dies zu gewährleisten, müssen die Zuleitungen zur Druckkammer 29 entsprechend dünn ausgelegt sein. Bei entsprechender Ausbildung des Druckstückes 49 kann bereits hier eine Vorverstärkung der Schwingungsamplitude auf mechanischem Weg erreicht werden. Das Piezoelement 48 wird durch nicht mehr dargestellte Versorgungsleitungen mit einer der Eigenfrequenz der Düsenanordnung entsprechenden hochfrequenten Sinus- oder Rechteckspannung angeregt. Da das Piezoelement 48 sandwichartig aus sehr vielen dünnen Schichten zusammengesetzt ist, genügen bereits geringe elektrische Spannungen, um heftige Kontraktionen bzw. Elongationen insbesondere im Bereich der Eigenfrequenz der Gesamtanordnung zu erzeugen. Das Piezoelement 48 wird statisch in seiner Längsrichtung durch eine Druckschraube 50 vorgespannt, und eine Kontramutter 51 sichert diese Schraubeneinstellung. Ein Gehäuse 52 schließt statisch und dynamisch den Kraftfluß aller Einzelbauteile. Die Bohrung 30 der Düse 2 ist in einem Saphirplättchen 53 ausgeführt, welchesvon einer Schraube 54 in eine Halterung 55 gepreßt und auf diese Weise dort fixiert wird. Durch die Wahl des Bohrungsmaterials Saphir wird die durch die Nadelschwingung bedingte Gefahr des Verreibens oder Verschweißens der Nadel 31, die aus einem metallischen Material besteht, mit der Bohrungswandung, ggf. unter Miteinbeziehung der von der Flüssigkeit mitgeführten Metallpigmente, weitgehend gemindert. Saphir als Bohrungsmaterial bringt auch dann wesentliche Vorteile, wenn die Abdeckflüssigkeit Kristalle enthält, die bei einem metallischen Bohrungsmaterial durch Abrasion oder Erosion einen hohen Verschleiß verursachen würden.

Es sei noch darauf hingewiesen, daß die Ringelektrode 33 mit einer Zuleitung 56 verbunden ist, um erstere mit einem elektrischen Potential über die Zuleitung 56 versorgen zu können.

Eine weitere Ausführungsform einer elektrostatischen Düse zur Durchführung des erfindungsgemäßen Verfahrens ist in Figur 5 gezeigt. Auch hier sind die gleichen Elemente wie in den Figuren 3 und 4 mit den gleichen Bezugszeichen versehen und werden nicht nochmals erläutert. Die Bohrung 30 ist bei diesem Ausführungsbeispiel so klein, beispielsweise im Enddurchmesser 17 µm, daß sie nicht mehr von der Nadel 31 in ihrer ganzen Länge durchsetzt werden kann. Die Nadel 31 reicht daher nur bis in die Nähe der engsten Bohrungsstelle. Die Wirkung der Nadel 31 ist aber ähnlich der Wirkung, die früher beschrieben wurde. Eine Schwingungsbewegung der Nadel 31 in Richtung zum Düsenaustritt steigert sowohl auf Grund der Wandschubkräfte als auch auf Grund der Verdrängungswirkung der Nadelstirnfläche 32 den Druck im Düseninnenraum 57. Die entsprechende Rücklaufbewegung der Nadel 31 bewirkt eine Druckminderung. Hierdurch werden wiederum starke Störungen dem austretenden Flüssigkeitsstrahl aufgeprägt und dieser zeigt eine starke Neigung zum geregelten und raschen Zerfall. Die Bildung der Einzeltropfen findet im Bereich der Ringelektrode 33 statt, die auch hier mit einer geeigneten Zuleitung zum Anlegen eines elektrostatischen Potentials versehen ist. Der Düseninnenraum 57, in welchem sich die Nadel 31 bewegt, wird durch einen Düsenkörper 58 erhalten, der aus Hartmetall oder Keramik hergestellt ist. Dieser Düsenkörper 58 ist in eine Bohrung 59 der Halterung 55 eingesetzt, wobei der Nadelhalter 46 noch teilweise in die Bohrung 59 hineinragen kann.

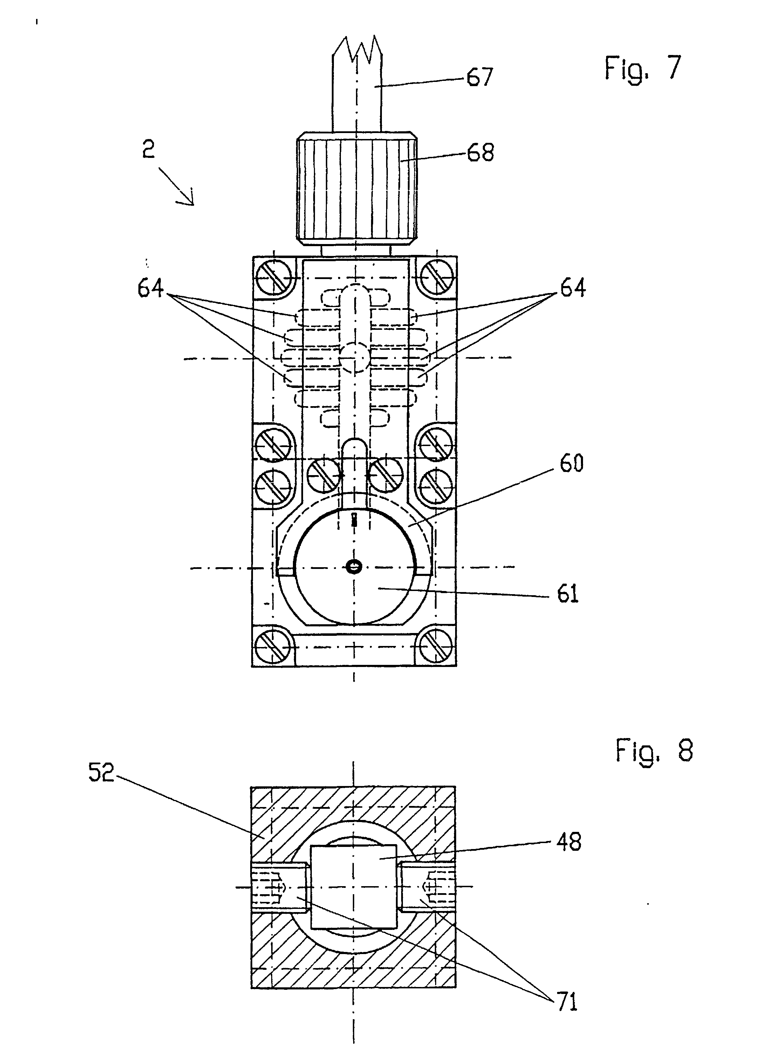

In den Figuren 6, 7 und 8 ist der Gesamtaufbau der Düse nach Fig. 5 dargestellt. Die Figur 6 zeigt den Schnitt durch einen Aufriß der Düse, die Figur 7 den Kreuzriß und die Figur 8 einen Querschnitt durch die Düse. Es sind wiederum gleiche Elemente wie in den Figuren 3 bis 5 mit den gleichen Bezugszeichen versehen und werden nicht nochmals beschrieben.

Ein Halter 60 preßt ein Mundstück 61, in welches die Ablenkelektrode 35 eingegossen ist, gegen den Düsengrundkörper 62. Der Düsenkanal 42 verläuft durch das Mundstück 61 hindurch und ist eingangsseitig mit der Ringelektrode 33 umgeben. Sie wird ebenfalls durch das Mundstück 61 getragen. Die schwingende Membran 47 befindet sich zwischen dem Gehäuse 52 und dem Düsengrundkörper 62. Dabei ist die schwingende Membran 47 zwischen Gehäuse 52 und Düsengrundkörper 62 eingespannt, wobei sie durch ein etwa 0,5 bis 1,0 mm dickes Stahlplättchen gebildet wird, welches wegen der besonderen Art der Einspannung nur in einem Umgebungsbereich der Nadel 31 Biegeschwingungen ausführen kann. Im darüberhinausragenden Bereich wird diese Membran 47 als Klemmelement für ein Mikrosieb 63 verwendet. Die relativ große Dicke der Membran bedingt Eigenfrequenzen, die zwischen 200 und 300 kHz liegen. Das Mikrosieb 63 ist zwischen der Membran 47 und dem Düsengrundkörper 62 eingespannt und verhindert, daß Partikel, die größer als 5 µm sind, und die unbeabsichtigt mit der Abdeckflüssigkeit mitgeführt werden, in das zur Düse führende Kanalsystem eintreten. Hier hilft die über das Mikrosieb 63 im Eintrittsbereich der Flüssigkeit geführte Membran 47 und die in diese eingeleitete Ultraschallschwingung eine Blockade des Mikrosiebes 63 durch sich verhakende Pigmente oder Kristalle zu vermeiden. Um eine möglichst große Filterfläche des Mikrosiebes 63 auszunutzen, wird dieses von einem System sehr kleiner feingefräster Stützkanäle 64 gehalten. Die Abdeckflüssigkeit wird durch die Versorgungsleitung 22 der Düse 2 zugeleitet. Diese Versorgungsleitung 22 ist mittels einer Überwurfmutter 65 auf ein Klemmstück 66 dicht aufgesetzt.

Über eine Luft- Wasserversorgungsleitung 67 wird die für die Reinigung und die Trocknung der Düse 2 erforderliche Flüssigkeit bzw. die notwendige Luft der Düse 2 im Bedarfsfall zugeführt. Auch diese Leitung 67 wird mit einer Überwurfmutter 68 gegen ein Einschraubklemmstück 69 gepreßt. Die Leitung 67 führt zu einem Umschaltventil 70, welches hier symbolisch dargestellt ist und sich in einer größeren Entfernung von der Düse 2 befindet.

In Figur 8 ist zu erkennen, daß das Piezoelement 48 innerhalb des Gehäuses 52 durch zwei kurze Gewindestifte 71 in einer Symmetrielage relativ zum Gehäuse 52 gehalten wird.

Die in den Figuren 3 bis 8 beschriebenen Elektrostatikdüsen eignen sich in besonderer Weise für die erfindungsgemäße Vorrichtung, da sich mit ihnen auch eine hochviskose bzw. zähe Abdeckflüssigkeit tropfenweise auf den Zylinder aufspritzen läßt, ohne daß dazu die Baulänge der Düse und damit die Abmessungen der Vorrichtung extrem große Werte annehmen müssen.

Die Erfindung ist auf die dargestellten Ausführungsbeispiele nicht beschränkt. So ist es denkbar, die Abdeckflüssigkeit nicht nur auf Rundzylinder aufzubringen sondern in ähnlicher Weise auch auf Flachformen, wobei anstelle der hier gezeigten Bewegung die Flachform z. B. flächendeckend nach Art eines Mäanders abgefahren wird.

## Patentansprüche

1. Vorrichtung zum Aufbringen einer Abdeckflüssigkeit auf einen Zylinder zur Herstellung von Flexodruckformen, mit einer Bearbeitungsstation, die
- wenigstens eine Lagereinrichtung (5, 6) zur stirnseitigen Lagerung eines Zylinders,
- eine Antriebseinrichtung (9, 10, 11) zur Drehung des Zylinders (1), um seine Zylinderachse (1b), einen parallel zur Zylinderachse (1b) bewegbaren Bearbeitungstisch (14) und
- eine Steuereinrichtung (4) zur Steuerung der Antriebseinrichtung (9, 10, 11), des Transports des Bearbeitungstisches (14) sowie zur Steuerung einer auf dem Bearbeitungstisch (14) angeordneten Werkzeugstation aufweist,
wobei die Werkzeugstation aus mehreren zur Ausspritzung von Abdeckflüssigkeit geeigneten Düsen (2) besteht, die in Längsrichtung des Zylinders (1) nebeneinander angeordnet sind.

2. Vorrichtung nach Anspruch 1, **dadurch gekennzeichnet, daß** jede Düse (2) mit einem Überdruckbehälter (21) für aufzuspritzende Abdeckflüssigkelt und mit einem Unterdruckbehälter (23) in Verbindung steht, in den von der Düse (2) ausgespritzte, unverbrauchte Abdeckflüssigkeit zurückgeführt wird.

3. Vorrichtung nach Anspruch 1 oder 2, **dadurch gekennzeichnet, daß** die Düsen (2) mit ihren Düsenlängsachsen (39) im wesentlichen horizontal liegen.

4. Vorrichtung nach Anspruch 1 oder 2, **dadurch gekennzeichnet, daß** die Düsen (2) mit ihren Düsenlängsachsen (39) im wesentlichen vertikal liegen.

5. Vorrichtung nach einem der Ansprüche 1 bis 4, **dadurch gekennzeichnet, daß** die Düsen (2) elektrischen Ausspritzsignale (S₁, S₂) von der Steuereinrichtung (4) in Übereinstimmung mit einem vorgegebenen Muster sowie in Abhängigkeit der Drehstellung des Zylinders (1) und der Position des Bearbeitungstisches (14) empfangen.

6. Vorrichtung nach Anspruch 5, **dadurch gekennzeichnet, daß** die Düsen (2) unterschiedliche Bereiche des Zylinders (1) beaufschlagen und die Steuereinrichtung (4) die elektrischen Ausspritzsignale (S₁, S₂) zur jeweiligen in Transportrichtung des Bearbeitungstisches (14) weiter hinten liegenden Düsen (2) zeitverzögert ausgibt.

7. Vorrichtung nach einem der Ansprüche 1 bis 6. **dadurch gekennzeichnet, daß** sich in Drehrichtung des Zylinders (1) gesehen hinter dem jeweiligen Flüssigkeitsauftreffpunkt eine Heizeinrichtung (H) zur Erhitzung der auf den Zylinder (1) aufgespritzten Flüssigkeit befindet.

8. Vorrichtung nach Anspruch 7, **dadurch gekennzeichnet, daß** die Heizeinrichtung (H) auf dem Bearbeitungstisch (14) montiert ist.

9. Vorrichtung nach einem der Ansprüche 1 bis 8, **dadurch gekennzeichnet, daß** die Düsen (2) zur Ausspritzung einer Metallpigmente enthaltenden Abdeckflüssigkeit, insbesondere einer Silberhalogenidemulsion, vorzugsweise einer Silberbromid, Silberjodid und/oder Silberchlorid in Gelatine oder Polyvenylalkohohl enthaltenden Abdeckflüssigkeit geeignet sind.

10. Vorrichtung nach einem der Ansprüche 1 bis 9, **dadurch gekennzeichnet, daß** die Düsen (2) Elektrostatikdüsen sind.

## Claims

1. Apparatus for applying a covering liquid to a cylinder to produce flexographic printing formes, having a processing station which
- has at least one bearing device (5, 6) for mounting a cylinder at the ends,
- has a drive device (9, 10, 11) for rotating the cylinder (1) about its cylinder axis (1b), a processing table (14) that can be moved parallel to the cylinder axis (1b) and
- a control device (4) for controlling the drive device (9, 10, 11), the transporting of the processing table (14), and for controlling a tool station arranged on the processing table (14),
the tool station comprising a plurality of nozzles (2) suitable for spraying out covering liquid, which are arranged beside one another in the longitudinal direction of the cylinder (1).

2. Apparatus according to Claim 1, **characterized in that** each nozzle (2) is connected to a positive pressure container (21) for covering liquid to be sprayed out and to a vacuum container (23), into which unused covering liquid sprayed out from the nozzle (2) is led back.

3. Apparatus according to Claim 1 or 2, **characterized in that** the nozzles (2) are located with their nozzle longitudinal axes (39) substantially horizontal.

4. Apparatus according to Claim 1 or 2, **characterized in that** the nozzles (2) are located with their nozzle longitudinal axes (39) substantially vertical.

5. Apparatus according to one of Claims 1 to 4, **characterized in that** the nozzles (2) receive electric spraying signals (S₁, S₂) from the control device (4) in accordance with a predefined pattern and as a function of the rotational position of the cylinder (1) and of the position of the processing table (14).

6. Apparatus according to Claim 5, **characterized in that** the nozzles (2) act on different regions of the cylinder (1), and the control device (4) outputs the electric spraying signals (S₁, S₂) with a time delay to the respective nozzles (2) lying further back in the transport direction of the processing table (14).

7. Apparatus according to one of claims 1 to 6, **characterized in that**, as viewed in the direction of rotation of the cylinder (1), a heating device (H) for heating the liquid sprayed onto the cylinder (1) is located behind the respective point of incidence of the liquid.

8. Apparatus according to claim 7, **characterized in that** the heating device (H) is mounted on the processing table (14).

9. Apparatus according to one of claims 1 to 8, **characterized in that** the nozzles (2) are suitable for spraying out a covering liquid containing metal pigments, in particular a silver halide emulsion, preferably a covering liquid containing silver bromide, silver iodide and/or silver chloride in gelatine or polyvinyl alcohol.

10. Apparatus according to one of claims 1 to 9, **characterized in that** the nozzles (2) are electrostatic nozzles.

## Revendications

1. Dispositif pour appliquer un liquide de recouvrement sur un cylindre en vue de la fabrication de plaques d'impression flexographiques avec une station de traitement qui présente
- au moins un dispositif de positionnement (5, 6) pour positionner un cylindre du côté frontal,
- un dispositif d'entraînement (9, 10, 11) pour faire tourner le cylindre (1) autour de son axe de cylindre (1b), une table de traitement (14) pouvant se déplacer parallèlement à l'axe du cylindre (1b) et
- un dispositif de commande (4) pour commander le dispositif d'entraînement (9, 10, 11), le déplacement de la table de traitement (14) ainsi que pour commander une station d'outillage placée sur la table de traitement (14), la station d'outillage étant composée de plusieurs buses (2) pour pulvériser le liquide de recouvrement, buses qui sont placées les unes à côté des autres en direction longitudinale du cylindre (1).

2. Dispositif selon la revendication 1, **caractérisé en ce que** chaque buse (2) est en relation avec un réservoir de surpression (21) pour le liquide de recouvrement à pulvériser et à un réservoir de sous-pression (23), dans lequel du liquide de recouvrement pulvérisé par la buse (2) et inutilisé est reconduit.

3. Dispositif selon la revendication 1 ou 2, **caractérisé en ce que** les buses (2) se trouvent avec leur axe longitudinal (39) sensiblement à l'horizontale.

4. Dispositif selon la revendication 1 ou 2, **caractérisé en ce que** les buses (2) se trouvent avec leur axe longitudinal (39) sensiblement à la verticale.

5. Dispositif selon l'une des revendications 1 à 4, **caractérisé en ce que** les buses (2) reçoivent du dispositif de commande (4) des signaux électriques de pulvérisation (S₁, S₂) conformément à un motif donné ainsi qu'en fonction de la position de rotation du cylindre (1) et de la position de la table de traitement (14).

6. Dispositif selon la revendication 5, **caractérisé en ce que** les buses (2) alimentent différentes zones du cylindre (1) et que le dispositif de commande (4) envoie avec temporisation les signaux électriques de pulvérisation (S₁, S₂) vers la buse respective se trouvant loin derrière dans la direction de déplacement de la table de traitement (14).

7. Dispositif selon l'une des revendications 1 à 6, **caractérisé en ce que** se trouve, vu dans le sens de rotation du cylindre (1) derrière chaque point d'impact du liquide, un dispositif de chauffage (H) pour réchauffer le liquide pulvérisé sur le cylindre (1).

8. Dispositif selon la revendication 7, **caractérisé en ce que** le dispositif de chauffage (H) est monté sur la table de traitement (14).

9. Dispositif selon l'une des revendications 1 à 8, **caractérisé en ce que** les buses (2) sont appropriées pour la pulvérisation d'un liquide de recouvrement contenant des pigments métalliques, en particulier d'un liquide de recouvrement contenant une émulsion d'halogénure d'argent, de préférence de bromure d'argent, de iodure d'argent et/ou de chlorure d'argent dans de la gélatine ou de l'alcool polyvinylique.

10. Dispositif selon l'une des revendications 1 à 6, **caractérisé en ce que** les buses (2) sont des buses électrostatiques.
